# DEMANDE DE BREVET EUROPEEN

(11) **EP 4 068 359 A1**
(43) Date de publication de la demande: **05.10.2022**
(21) Numéro de dépôt: 22164602.9
(22) Date de dépôt: 28.03.2022
(51) Int. Cl.: H01L 27/06, H01L 27/085, H01L 21/8252, H01L 29/778, H01L 29/417, H01L 29/20

(54) **DISPOSITIF ÉLECTRONIQUE COMPRENANT DEUX TRANSISTORS À HAUTE MOBILITÉ ÉLECTRONIQUE**

(30) Priorité: 30.03.2021 FR 2103238
(71) Demandeur: Exagan, 38040 Grenoble Cedex 9 (FR); STMicroelectronics International N.V./2, 1228 Plan-les-Ouates, Geneva (CH)
(72) Inventeur: NONGAILLARD, Matthieu, 38000 GRENOBLE (FR); OHEIX, Thomas, 38100 GRENOBLE (FR)
(74) Mandataire: Cabinet Beaumont

(57) **Abrégé**

L'invention concerne un dispositif électronique comprenant un transistor HEMT, dit transistor principal (102), et au moins un autre transistor HEMT, dit transistor additionnel (101), empilés l'un sur l'autre.

Le transistor principal et le transistor additionnel comprenant une électrode de drain (204) commune et, respectivement, une électrode de source (203) principale et une électrode de source (203) additionnelle, agencées de sorte que des chemins de conduction électrique susceptibles d'être formés par les deux couches de conduction soient connectés en parallèle lorsque l'un et l'autre des transistors HEMT sont dans l'état passant.

## Description

### DOMAINE DE L'INVENTION

L'invention se rapporte au domaine de l'électronique, et notamment de l'électronique de puissance. Plus particulièrement, la présente invention concerne un dispositif électronique pourvu de deux transistors à haute mobilité électronique.

Le dispositif selon la présente invention est notamment agencé pour permettre un meilleure intégration des deux transistors à haute mobilité électronique.

L'agencement prévu dans la présente invention permet à cet égard l'obtention d'un dispositif compact et permettant d'augmenter la densité de courant susceptible de traverser ledit le dispositif au regard d'un unique transistor à haute mobilité électronique.

### ARRIERE PLAN TECHNOLOGIQUE DE L'INVENTION

Les transistors à haute mobilité électronique (« HEMT » ou « High Electron Mobility Transistor » selon la terminologie Anglo-Saxonne), bien connus de l'homme du métier, sont aujourd'hui largement mis en œuvre dans le domaine des hyperfréquences et celui des commutateurs pour les convertisseurs en électronique de puissance.

A cet égard, ces transistors HEMT sont généralement élaborés à partir de couches de matériaux semi-conducteur III-V et plus particulièrement des matériaux semi-conducteur III-N.

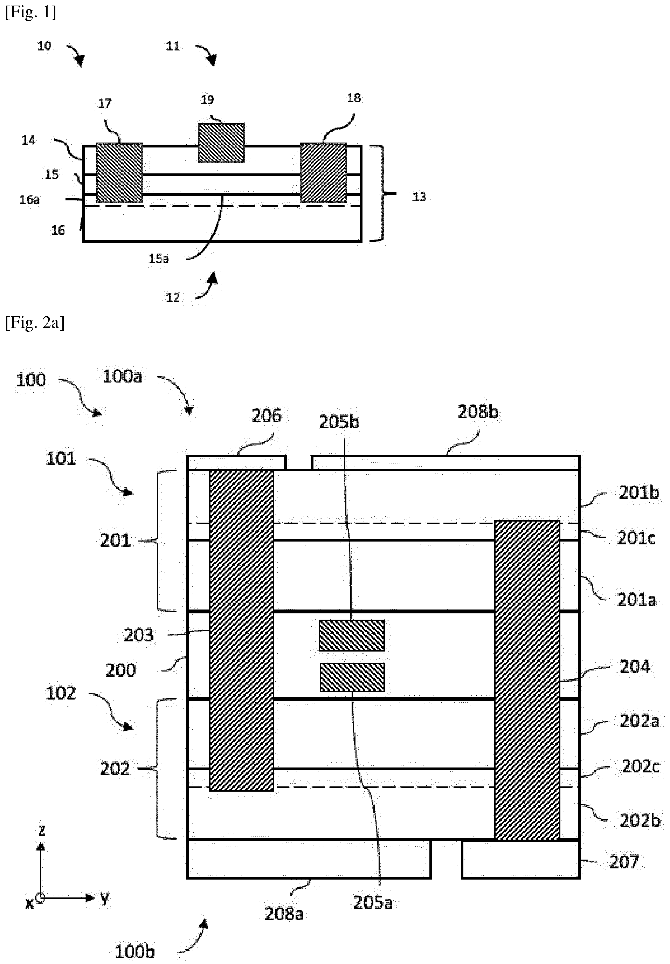

Notamment, la figure 1 représente un transistor HEMT 10 connu de l'état de la technique. Ce transistor HEMT 10 est pourvu d'un empilement 13 qui comprend, d'une face avant 11 vers une face arrière 12, une couche d'isolant 14, une couche barrière 15 et une couche canal 16 apte à former une couche de conduction 16a sous forme d'une couche de gaz électronique à deux dimensions. En particulier, la couche de conduction 16a s'étend dans la couche canal 16 à partir d'une interface 15a, formée entre la couche barrière 15 et ladite couche canal 16.

Les matériaux semi-conducteur III-V choisis pour former la couche barrière 15 et/ou la couche canal 16 peuvent comprendre du nitrure de gallium (GaN), du nitrure d'aluminium (AlN), des alliages ternaires AlxGa1-xNx, de l'arséniure de gallium (GaAs), des alliages de ternaires d'AlGaAs ou d'InGaAs. Par exemple, la couche barrière 15 et la couche canal 16 peuvent comprendre, respectivement, un composé d'AlGaN et du GaN. La couche d'isolant 14 peut comprendre un matériau diélectrique et notamment du dioxyde de silicium (SiO2) ou nitrure de silicium (Si3N4).

Le transistor HEMT 10 comprend également une électrode de source 17 et une électrode de drain 18 en contact électrique avec la couche de conduction 16a. Plus particulièrement, l'électrode de source 17 et l'électrode de drain 18 débouchent par la face avant 11, et traversent la couche barrière 15 afin d'atteindre l'interface 15a et contacter électriquement la couche de conduction 16a. L'électrode de source 17 et de l'électrode de drain 18 peuvent traverser partiellement ou intégralement la couche de conduction 16a. L'électrode de source 17 et l'électrode de drain 18 peuvent comprendre une espèce métallique, par exemple de l'aluminium, remplissant des tranchées formées dans l'empilement 13.

Le transistor HEMT 10 comprend également une électrode de grille 19 destinée à se voir imposer une tension V permettant de contrôler l'état de la couche de conduction 16a. Notamment, dès lors que la différence de potentiel électrique entre l'électrode de grille 19 et l'électrode de source 17, notée Vg-Vs, est supérieure à une tension de seuil Vth caractéristique du transistor HEMT 10, ledit transistor est dans l'état passant. A contrario, dès lors que Vg-Vs est inférieure à Vth, le transistor HEMT 10 est dans l'état non-passant, et se comporte donc comme un interrupteur ouvert.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Un tel transistor à haute mobilité électronique présente toutefois une résistivité Ron (Ron étant la résistance drain/source à l'état passant)à l'état passant qui limite l'intensité du courant susceptible de circuler dans la couche de conduction.

A cet égard, les principaux paramètres influençant la résistivité Ron sont :
- la résistance surfacique de la couche canal ;
- la résistance des contacts entre la couche de conduction et les électrodes de source et de drain ;
- les résistivités électriques des métaux de routage des puces ;
- les résistances électriques induites dans l'assemblage final dans lequel est intégré le transistor à haute mobilité électronique.

Afin de pallier ce problème, il est possible de réduire de manière significative la résistivité Ron d'un transistor à haute mobilité électronique en augmentant la surface de ce dernier. Il est néanmoins des situations pour lesquelles l'espace disponible pour l'intégration d'un transistor à haute mobilité électronique est contraint de sorte que telle solution ne puisse être envisagée.

De manière alternative, il peut être considéré d'optimiser les paramètres influençant la résistivité Ron. Une telle solution reste cependant complexe à mettre en œuvre, car elle nécessite, d'une part, un redimensionnement complet du transistor à haute mobilité électronique, et d'autre part une revue du procédé permettant de fabriquer ledit transistor.

Un but de la présente invention est donc de proposer un dispositif dont l'agencement permet une densité d'intégration de transistors à haute mobilité électronique plus importante sans toutefois augmenter de manière significative l'espace occupé par ledit dispositif.

Un autre but de la présente invention est également de proposer un dispositif permettant une gestion efficace des courants d'appel.

### BREVE DESCRIPTION DE L'INVENTION

Le but est atteint par un dispositif électronique comprenant un transistor HEMT, dit transistor principal, et au moins un autre transistor HEMT, dit transistor additionnel, le transistor principal et le transistor additionnel étant pourvus, respectivement, d'un empilement principal et d'un empilement additionnel entre lesquels est intercalée une couche isolante, l'empilement principal et l'empilement additionnel s'étendant, de la couche isolante vers, respectivement, une face arrière et une face avant du dispositif électronique, et comprennant chacun, à partir de la couche isolante, une couche barrière et une couche canal qui, lorsque le transistor HEMT considéré passe d'un état non-passant vers un état passant, est apte à former une couche de conduction, le transistor principal et le transistor additionnel comprenant une électrode de drain commune et, respectivement, une électrode de source principale et une électrode de source additionnelle, agencées de sorte que des chemins de conduction électrique susceptibles d'être formés par les deux couches de conduction soient connectés en parallèle lorsque l'un et l'autre des transistors HEMT sont dans l'état passant, le passage de l'un de l'état non-passant et de l'état passant vers l'autre de ces deux états étant contrôlé de manière indépendante pour l'un et l'autre du transistor principal et du transistor additionnel via, respectivement, une électrode de grille principale et une électrode de grille additionnelle.

Ainsi, selon la présente invention il est possible d'augmenter la densité de transistors à haute mobilité électronique sans pour autant augmenter la surface que le dispositif électronique occupe.

Par ailleurs, la mise en parallèle des couches de conduction des deux transistors permet d'augmenter le courant susceptible de circuler dans le dispositif électronique et ainsi ouvrir la voie à des applications plus haute puissance. Ainsi, selon la présente invention, dès lors que le courant circulant dans le transistor principal dépasse une valeur seuil, il est possible de rendre le transistor additionnel passant.

En outre, le dispositif électronique selon la présente invention ne nécessite pas de redimensionnement des transistors à haute mobilité électronique qu'il comprend.

Par surcroit, la connexion en parallèle des chemins de conduction permet de limiter la résistivité Ron du dispositif électronique.

Selon un mode de réalisation, l'électrode de drain traverse la couche isolante, et s'étend de part et d'autre de ladite couche isolante pour contacter électriquement la couche canal de l'un et l'autre du transistor principal et du transistor additionnel, avantageusement, le dispositif électronique comprend un plot, dit plot drain, disposé sur la face arrière et permettant de contacter électriquement l'électrode de drain.

Selon un mode de réalisation, ledit dispositif électrique comprend un plot, dit plot de grille principal, disposé sur la face arrière et permettant de contacter électriquement l'électrode de grille principale et un plot, dit plot de grille additionnel, disposé sur la face avant et permettant de contacter électriquement l'électrode de grille additionnelle.

Selon un mode de réalisation, le transistor principal et le transistor additionnel sont des transistors HEMT en mode enrichissement, et dans lequel l'électrode de source principale et l'électrode de source additionnelle forment une unique électrode de source, avantageusement, l'électrode de source traverse la couche isolante, et s'étend de part et d'autre de ladite couche isolante pour contacter électriquement la couche canal de l'un et l'autre du transistor principal et du transistor additionnel.

Selon un mode de réalisation, ledit dispositif électronique comprend un plot dit plot source permettant de contacter électriquement l'électrode de source.

Selon un mode de réalisation, le plot source est disposé sur la face avant.

Selon un mode de réalisation, le transistor principal et le transistor additionnel sont des transistors HEMT en mode déplétion, et sont chacun cascodés avec un transistor MOSFET dit, respectivement, transistor MOSFET principal et transistor MOSFET additionnel.

Selon un mode de réalisation, le transistor MOSFET principal et le transistor MOSFET additionnel sont agencés pour imposer, de manière indépendante, un état passant ou un état non-passant, respectivement, au transistor principal et au transistor additionnel.

Selon un mode de réalisation, ledit dispositif électronique comprend en outre deux plots dits plot source principal et plot source additionnel permettant de contacter électriquement, respectivement, l'électrode de source principale et l'électrode de source additionnelle, le plot source principal et le plot source additionnel étant disposés, respectivement, sur la face arrière et sur la face avant.

Selon un mode de réalisation, l'empilement principal et l'empilement additionnel sont essentiellement identiques.

Selon un mode de réalisation, le transistor principal et le transistor additionnel présentent une tension de seuil identique.

Selon un mode de réalisation, le transistor principal et le transistor additionnel présentent chacun, respectivement, une tension de seuil principale et une tension de seuil additionnelle différentes l'une de l'autre.

Selon un mode de réalisation, les deux couches canal comprennent du GaN et les couches barrière comprennent un alliage ternaire d'AlGaN.

Selon un mode de réalisation, la couche isolante comprend un matériau diélectrique, avantageusement, du dioxyde de silicium.

La mise en œuvre de la couche isolante est particulièrement avantageuse, dans la mesure où elle permet d'isoler efficacement les deux couches barrière.

La considération de cette couche isolante simplifie également l'assemblage des deux transistors à haute mobilité électronique. En effet, cette dernière permet de considérer un assemblage par collage moléculaire des deux transistors.

L'invention concerne également un boîtier électronique comprenant :
- le dispositif électronique selon la présente invention ;
- un moyen de contrôle du passage de l'un de l'état non-passant et de l'état passant vers l'autre de ces deux états, du transistor principal et du transistor additionnel, le moyen de contrôle étant configuré pour rendre passant le transistor additionnel dès lors que le transistor principal est lui-même dans l'état passant et que le courant le traversant est supérieur à une valeur seuil.

### BREVE DESCRIPTION DES DESSINS

D'autres caractéristiques et avantages de l'invention ressortiront de la description détaillée qui va suivre en référence aux figures annexées sur lesquelles :
La figure 1 est une représentation schématique d'un transistor HEMT connu de l'état de la technique, notamment, le transistor HEMT est représenté selon un plan de coupe perpendiculaire à la face avant ;
La figure 2a est une représentation schématique d'un dispositif électronique, selon un plan de coupe, conforme au premier mode de réalisation de la présente invention ;
La figure 2b est une représentation illustrant le positionnement déporté du plot grille principal et du plot de grille additionnel permettant de connecter électriquement l'électrode de grille principale et l'électrode de grille additionnelle du dispositif électronique de la figure 2a ;
La figure 2c est une représentation illustrant le positionnement déporté d'un plot grille additionnel permettant de connecter électriquement l'électrode de grille additionnelle du dispositif électronique de la figure 2a selon une vue par la face avant dudit dispositif ;
La figure 3 est une représentation schématique d'un dispositif électronique, selon un plan de coupe, conforme au deuxième mode de réalisation de la présente invention ;
La figure 4 est une représentation fonctionnelle d'un boîtier mettant en œuvre le dispositif électronique selon le premier mode de réalisation de la présente invention ;
La figure 5 est une représentation schématique d'une étape de formation d'un transistor additionnel selon les termes de la présente invention ;
La figure 6 est une représentation schématique d'une étape de formation d'un transistor principal selon les termes de la présente invention ;
La figure 7 est une représentation schématique d'une étape de formation de plots destinés à contacter électriquement les électrodes de source et de grille.

### DESCRIPTION DETAILLEE DE L'INVENTION

Bien sûr, l'invention n'est pas limitée aux modes de réalisation décrits et on peut y apporter des variantes de réalisation sans sortir du cadre de l'invention tel que défini par les revendications.

Par ailleurs, il est entendu que les différentes figures présentées en relation avec la présente description ne sont données qu'à titre d'illustration et ne limitent en aucune manière l'invention. Il est notamment clair que les échelles ou dimensions relatives peuvent ne pas être respectées.

Dans toute la description, il est admis qu'une couche ou une interface est généralement plane et s'étend selon un plan parallèle au plan (0, x, y) du repère orthonormé (0, x, y, z). Par ailleurs, dès qu'il est fait référence à une représentation selon un plan de coupe, ce dernier est perpendiculaire à l'ensemble des plans formés par les couches, et plus particulièrement perpendiculaire au plan (0, x, y). Il est également entendu que, dès lors qu'il est fait référence à un empilement de couches, ces dernières sont empilées selon la direction z du repère orthonormé (0, x, y, z).

L'invention concerne un dispositif électronique comprenant un transistor HEMT, dit transistor principal, et au moins un autre transistor HEMT, dit transistor additionnel.

Le transistor principal et le transistor additionnel sont pourvus, respectivement, d'un empilement principal et d'un empilement additionnel entre lesquels est intercalée une couche isolante.

L'empilement principal et l'empilement additionnel s'étendent, de la couche isolante vers, respectivement, une face arrière et une face avant du dispositif électronique, et comprennent chacun, à partir de la couche isolante, une couche barrière et une couche canal.

En particulier, dès lors qu'il passe d'un état non-passant vers un état passant, le transistor HEMT considéré est apte à former, dans la couche canal, une couche de conduction. Notamment cette couche de conduction prend la forme d'un gaz d'électrons à deux dimensions, et s'étend dans la couche canal à partir de l'interface formée entre la couche barrière et la couche canal.

Le transistor principal et le transistor additionnel comprennent une électrode de drain commune et, respectivement, une électrode de source principale et une électrode de source additionnelle, agencées de sorte que des chemins de conduction électrique susceptibles d'être formés par les deux couches de conduction soient connectés en parallèle lorsque l'un et l'autre des transistors HEMT sont dans l'état passant.

Le passage de l'un de l'état non-passant et de l'état passant vers l'autre de ces deux états, est contrôlé de manière indépendante pour l'un et l'autre du transistor principal et du transistor additionnel via, respectivement, une électrode de grille principale et une électrode de grille additionnelle.

Cette configuration est avantageuse à plusieurs égards. En effet, la mise en parallèle des canaux de conduction des deux transistors permet d'augmenter l'intensité du courant susceptible de circuler dans le dispositif électronique sans avoir à augmenter sa surface. Notamment, lorsque le courant circulant dans le transistor principal dépasse une valeur seuil, il est possible de rendre passant le transistor additionnel de manière à former une couche de conduction dans ledit transistor connectée en parallèle avec la couche de conduction du transistor additionnel.

Par ailleurs, cette mise en parallèle permet également de réduire la résistivité à l'état passant Ron du dispositif électronique.

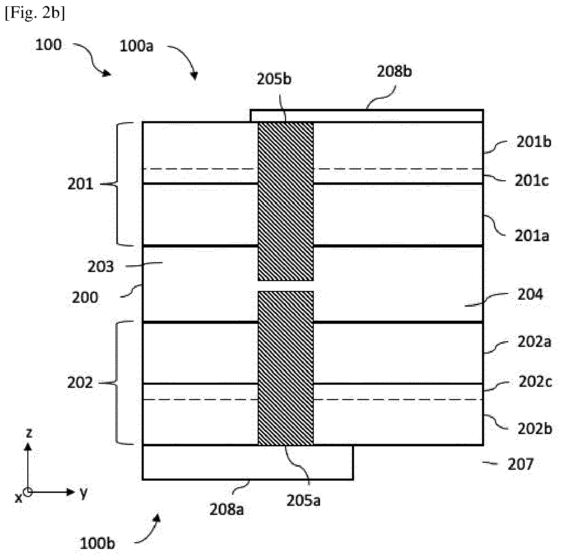

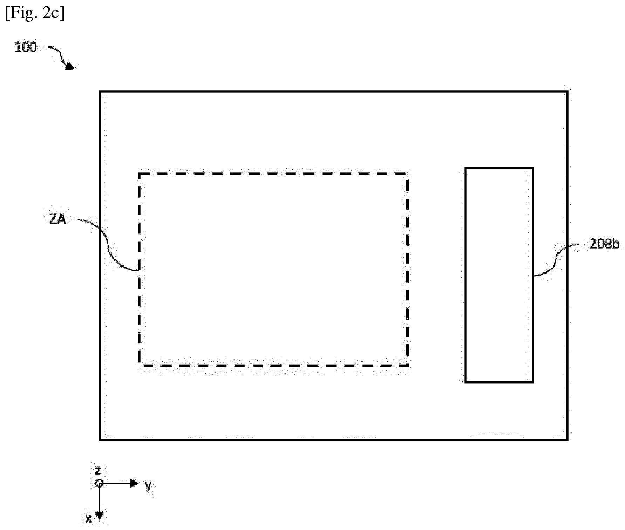

A la figure 2, on peut voir un exemple de dispositif électronique 100 selon un premier mode de réalisation de la présente invention.

Ainsi, le dispositif électronique 100 selon la présente invention comprend des transistors à haute mobilité électronique (ci-après « transistor HEMT ») . Notamment, le dispositif électronique 100 comprend, d'une face avant 100a vers une face arrière 100b, au moins un transistor additionnel 101 et un transistor principal 102 séparés par une couche isolante 200. La couche isolante 200 comprend avantageusement du dioxyde de silicium ou du nitrure de silicium.

Selon ce premier mode de réalisation, les transistors HEMT sont en mode enrichissement (« Enhancement mode » selon la terminologie Anglo-Saxonne). En d'autres termes, un tel transistor présente une tension de seuil Vth positive (un tel transistor est donc passant lorsque la différence de potentiel Vg-VS appliquée entre l'électrode de grille et l'électrode de source est supérieure à Vth).

La description de la présente invention se limitera à la mise en œuvre d'un unique transistor additionnel. Toutefois, cet aspect n'est pas de nature à limiter la portée de la présente invention. Notamment, l'homme du métier, sur la base de ses connaissances générales et de la description qui suit, est en mesure de mettre en œuvre, dans le cadre de la présente invention, une pluralité de transistors additionnels.

Le transistor additionnel 101 et le transistor principal 102 comprennent chacun un empilement dit, respectivement, empilement additionnel 201 et empilement principal 202. Chacun de ces empilements peut notamment comprendre des matériaux semi-conducteurs du groupe III-V, et plus particulièrement des matériaux semi-conducteurs du groupe III-N. Les matériaux semi-conducteurs du groupe III-V pourront notamment être choisis parmi le nitrure de gallium (GaN), le nitrure d'aluminium (AlN) et leurs alliages ternaires AlxGa1-xN, ou parmi l'arséniure de gallium (GaAs) et ses composés (AlGaAs, InGaAs).

L'empilement additionnel 201 et l'empilement principal 202 comprennent chacun une couche barrière et une couche canal. Notamment, l'empilement additionnel 201 comprend, de la couche isolante 200 vers la face avant 100a, une couche barrière additionnelle 201a et une couche canal additionnelle 201b. De manière équivalente, l'empilement principal 202 comprend, de la couche isolante 200 vers la face arrière 100b, une couche barrière principale 202a et une couche canal principale 202b.

A titre d'exemple et selon la présente invention, une couche barrière peut comprendre un alliage ternaire d'AlxGa1-xN, tandis qu'une couche canal peut comprendre du GaN.

Par ailleurs, une couche barrière peut présenter une épaisseur comprise entre 1 nm et 100 nm.

Une couche canal peut présenter une épaisseur comprise entre 10 nm et 2 µm.

Un empilement 201 ou 202, selon les termes de la présente invention, est apte à former une couche de gaz d'électrons à deux dimensions (2DEG pour « 2-dimensional electron gaz ») qui constitue une couche de conduction.

La couche de conduction, au sein d'un empilement, s'étend dans la couche canal, à partir de l'interface formée entre la couche barrière et la couche canal de l'empilement considéré.

Ainsi, l'empilement additionnel 201 comprend une couche de conduction additionnelle 201c qui s'étend dans la couche canal additionnelle 201b, à partir d'une interface additionnelle formée entre la couche barrière additionnelle 201a et la couche canal additionnelle 201b.

De manière équivalente, l'empilement principal 202 comprend une couche de conduction principale 202c qui s'étend dans la couche canal principale 202b, à partir d'une interface principale formée entre la couche barrière principale 202a et la couche canal principale 202b.

Le dispositif électronique 100 comporte une électrode de source 203 et une électrode de drain 204 en contact électrique avec l'une et l'autre de la couche de conduction additionnelle 201c et de la couche de conduction principale 202c. Rappelons que différents types de contacts électriques sont connus pour connecter électriquement les électrodes de sources 203 et de drain 204 une couche de conduction 201c, 202c : en particulier, des contacts ohmiques, tunnel ou Schottky.

En particulier, l'électrode de source 203 et l'électrode de drain 204 traversent la couche isolante 200, et s'étendent chacune de part et d'autre de ladite couche isolante 200 pour, chacune, contacter électriquement la couche de conduction additionnelle 201c et la couche de conduction principale 202c.

Le dispositif électrique 100 peut comprendre un plot, dit plot source 206, disposé sur la face avant 100a et permettant de contacter électriquement l'électrode de source 203. Le plot source 206 comprend avantageusement du silicium dopé.

Le dispositif électrique 100 peut comprendre un plot, dit plot drain 207, disposé sur la face arrière 100b et permettant de contacter électriquement l'électrode de drain 204. Le plot drain 207 peut avantageusement comprendre du silicium dopé.

La couche de conduction d'un transistor HEMT, lorsque ce dernier est passant, est destinée à assurer la conduction d'un courant électrique entre l'électrode de source et l'électrode de drain du transistor HEMT considéré.

Le dispositif électronique 100 selon la présente invention comprend également deux électrodes de grille distinctes l'une de l'autre (i.e. : électriquement isolées l'une de l'autre). Notamment, le dispositif électronique 100 comprend une électrode de grille principale 205a et une électrode de grille additionnelle 205b.

Le dispositif électrique 100 peut comprendre un plot, dit plot grille principal 208a, disposé sur la face arrière et permettant de contacter électriquement l'électrode de grille principale.

De manière équivalente, le dispositif électrique 100 peut comprendre un plot, dit plot grille additionnel 208b, disposé sur la face avant et permettant de contacter électriquement l'électrode de grille additionnelle.

Il est entendu que, pour chaque transistor HEMT, le contact électrique entre une électrode de grille et le plot de grille qui lui est associé est déportée de manière à ne pas risquer de contacter électriquement la couche de conduction du transistor considéré. Notamment, le plot grille principal et le plot grille additionnel sont déportés d'une zone active du dispositif électronique (figure 2b). Par « déporté », on entend un plot grille qui est disposé en dehors d'un contour délimitant l'un et l'autre des deux transistors. A cet égard, la figure 2c est une représentation du dispositif 100 selon une vue par la face avant (selon un plan parallèle au plan (0, x, y)). Les pointillés délimitent une section active ZA du dispositif électronique au sein de laquelle tout contact entre l'électrode de grille et l'une et l'autre des couches barrière et canal est évité.

Ainsi, l'électrode de grille principale 205a est agencée pour contrôler le transistor principal 102, et plus particulièrement contrôler le passage de l'un de l'état non-passant et de l'état passant vers l'autre de ces deux états.

De manière équivalente, l'électrode de grille additionnelle 205b est agencée pour contrôler le transistor additionnel 101, et plus particulièrement contrôler le passage de l'un de l'état non-passant et de l'état passant vers l'autre de ces deux états.

Par « état passant », on entend un transistor dans lequel un courant est susceptible de circuler entre l'électrode de source et l'électrode de drain. Notamment, un transistor HEMT, lorsqu'il se trouve dans l'état passant, comprend une couche de conduction tel que définie précédemment.

Par « état non-passant », on entend un transistor qui se comporte comme un interrupteur ouvert de sorte qu'aucun courant ne peut circuler entre son électrode de source et l'électrode de drain.

Plus particulièrement, un transistor HEMT bascule d'un état non-passant vers un état passant dès lors que la différence de potentiel Vg-Vs entre l'électrode de grille et l'électrode de source est supérieure à la tension seuil Vth du transistor considéré.

Ainsi, selon la présente invention, le transistor principal 102 et le transistor additionnel 101 peuvent être contrôlés de manière indépendante. Plus particulièrement, le transistor principal et le transistor additionnel peuvent être, dépendamment de la tension appliquée à leur électrode de grille, dans le même état ou dans un état différent.

Par exemple, dès qu'il s'agit de faire circuler un courant dans le dispositif électronique 100, il est possible de commander, en premier lieu, le passage de l'état non-passant vers l'état passant du transistor principal tout en conservant le transistor additionnel dans l'état non-passant. Ces états passant et non-passant, respectivement, du transistor principal et du transistor additionnel peuvent être conservés tant que le courant reste inférieur à une valeur de courant seuil Is.

La valeur de courant seuil Is peut être inférieure ou égale à une valeur de courant de dégradation Id. La valeur de courant de dégradation Id correspond à une valeur de courant au-delà de laquelle le transistor principal risque d'être dégradé

A titre d'exemple, la valeur de courant seuil Is peut être inférieure à la moitié de la valeur de courant de dégradation Id.

Ainsi, la mise en œuvre du transistor additionnel 101 permet de protéger le transistor principal, notamment lors de l'apparition de courants d'appel.

De manière alternative ou complémentaire, le transistor additionnel 101 peut être mis en œuvre dès lors que le transistor principal oppose une résistance Ron trop importante au passage du courant dans sa couche de conduction. Un tel effet peut notamment intervenir lorsque la température du dispositif électronique augmente.

Toujours de manière alternative, le transistor additionnel 101 peut être mis en œuvre pour absorber un pic de courant susceptible de survenir dans le transistor principal lors du passage de l'état non-passant vers l'état passant de ce dernier. A cette fin, le passage à l'état passant du transistor additionnel concomitant avec le passage à l'état passant du transistor principal permet de pallier l'apparition d'un pic de courant.

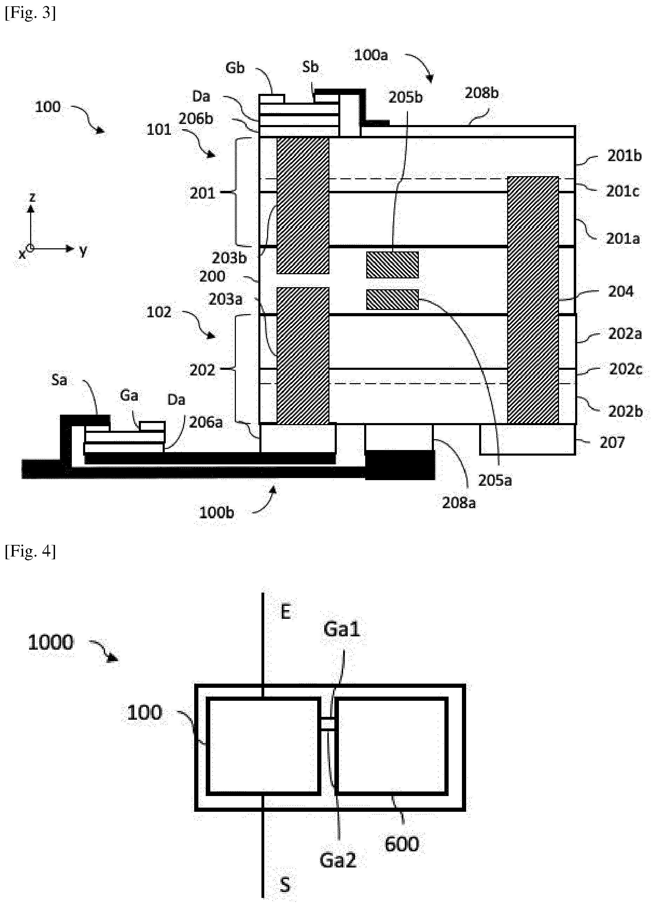

A la figure 3 on peut voir un dispositif électronique 100 selon un deuxième mode de réalisation de la présente invention. Ce deuxième mode de réalisation reprend l'essentiel des caractéristiques décrites en relation avec la figure 2.

Selon ce deuxième mode de réalisation, les transistors HEMT sont en mode déplétion ou normalement passant (« Depletion mode » selon la terminologie Anglo-Saxonne). En d'autres termes, un tel transistor présente une tension de seuil Vth inférieure à 0 (un tel transistor est donc passant lorsque la différence de potentiel appliquée entre l'électrode de grille et l'électrode de source est nulle).

Selon ce deuxième mode de réalisation, le transistor principal 102 et le transistor additionnel ne partagent plus la même électrode de source.

Notamment, le transistor principal 102 comprend une électrode de source, dite électrode de source principale 203a qui traverse l'empilement principal 202, et émerge par la face arrière 100b. Le dispositif électronique comprend à cet égard un plot, dit plot source principal 206a disposé sur la face arrière 100b et permettant d'établir un contact électrique avec l'électrode de source principale 203a.

De manière équivalente, le transistor additionnel 101 comprend une électrode de source, dite électrode de source additionnelle 203b qui traverse l'empilement additionnel 201, et émerge par la face avant 100a. Le dispositif électronique comprend à cet égard un plot, dit plot source additionnel 206b disposé sur la face avant 100b et permettant d'établir un contact électrique avec l'électrode de source additionnelle 203b.

Selon ce deuxième mode de réalisation, le transistor principal et le transistor additionnel sont chacun cascodés avec un transistor MOSFET.

Notamment, le transistor principal 102 est cascodé, par sa source, avec un transistor MOSFET dit transistor MOSFET principal. Ce dernier comprend une source Sa connectée avec l'électrode de grille principale 205a, un drain Da connecté avec l'électrode de source principale 203a, et une grille Ga permettant de contrôler le passage d'un état passant vers un état non-passant ou inversement du transistor MOSFET principal.

De manière équivalente, le transistor additionnel 101 est cascodé, par sa source, avec un transistor MOSFET dit transistor MOSFET additionnel. Ce dernier comprend une source Sb connectée avec l'électrode de grille additionnelle 205b, un drain Db connecté avec l'électrode de source additionnelle 203b, et une grille Gb permettant de contrôler le passage d'un état passant vers un état non-passant ou inversement du transistor MOSFET additionnel.

Aussi, toujours selon ce deuxième mode de réalisation, les sources Sa et Sb sont également électriquement connectés.

Selon ce deuxième mode de réalisation l'électrode de grille principale et l'électrode de grille additionnelle sont contrôlées par, respectivement, la grille Ga et la grille Gb.

Le fonctionnement du dispositif électronique selon ce deuxième mode de réalisation est similaire à celui évoqué dans le cadre du premier mode de réalisation.

Quel que soit le mode de réalisation envisagé, le dispositif électronique selon la présente invention peut être intégré à un boîtier électronique 1000 pourvu d'un moyen de contrôle 600 (figure 4). Le boîtier électronique comprend en particulier une entrée E et une sortie S connectées, respectivement, à l'électrode de source et à l'électrode de drain.

Le moyen de contrôle 600 est notamment configuré pour contrôler le passage de l'un de l'état non-passant et de l'état passant vers l'autre de ces deux états, du transistor principal et du transistor additionnel. En particulier, le moyen de contrôle est connecté au dispositif électronique 100 via une connexion Ga1 et une connexion Ga2 destinées à imposer une tension, respectivement, à l'électrode de grille principale et à l'électrode de grille additionnelle.

Plus particulièrement, le moyen de contrôle 600 est configuré pour rendre passant le transistor additionnel dès lors que le transistor principal est lui-même dans l'état passant et que le courant le traversant est supérieur à la valeur seuil Is.

Notamment, le moyen de contrôle 600 peut être configuré pour synchroniser l'électrode de grille principale et l'électrode de grille additionnelle afin de limiter les pics de courant susceptibles d'apparaître lors du passage à l'état passant de ces deux transistors.

L'homme du métier, sur la base de ses connaissances générales, est en mesure de concevoir un tel système. Il pourra notamment consulter le document Y. Wen, M. Rose, R. Fernandes, R. Van Otten, H. J. Bergveld and O. Trescases, "A Dual-Mode Driver IC With Monolithic Negative Drive-Voltage Capability and Digital Current-Mode Controller for Depletion-Mode GaN HEMT," in IEEE Transactions on Power Electronics, vol. 32, no. 1, pp. 423-432, Jan. 2017.

La présente invention concerne également un procédé de fabrication du dispositif électronique 100 décrit ci-avant. Le procédé de fabrication est décrit uniquement dans le cadre de la formation du dispositif électronique 100 selon le premier mode de réalisation. L'homme du métier pourra sur la base de ses connaissances générales et des concepts présentés ci-après adapter le procédé pour le mettre en œuvre dans le cadre du deuxième mode de réalisation.

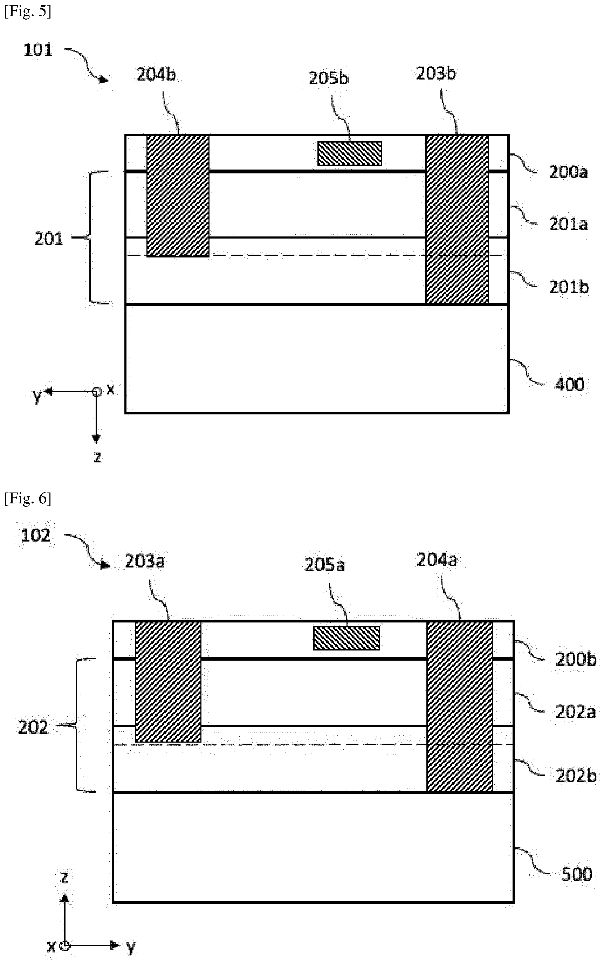

Notamment, le procédé comprend une étape de formation d'un transistor additionnel 101 (figure 5).

Notamment, la formation de ce transistor additionnel 101 comprend une croissance épitaxiale de l'empilement additionnel 201 sur une première face d'un premier substrat 400, par exemple un substrat de silicium. La croissance épitaxiale peut notamment comprendre en premier lieu la formation de la couche canal additionnelle 201b, puis en second lieu, la formation de la couche barrière additionnelle 201a. De manière avantageuse, la formation de la couche canal additionnel peut être précédée de la formation d'une couche d'adaptation additionnelle (sur laquelle doit reposer la couche canal additionnel). La couche d'adaptation additionnelle est notamment destinée à limiter la formation des dislocations dans la couche canal additionnel.

La croissance épitaxiale est suivie de la formation, en recouvrement de la couche barrière additionnelle 201a, d'une première couche isolante 200a, qui comprend par exemple du dioxyde de silicium, ou du nitrure de silicium.

Le dépôt de la couche isolante 200a est alors suivi de la formation d'une première électrode de source 203b, d'une première électrode de drain 204b et d'une première électrode de grille 205b. Les deux électrodes 203b et 204b s'étendent notamment d'une surface libre de la première couche isolante vers ou dans l'empilement additionnel 201.

Le procédé de fabrication comprend une étape de formation d'un transistor principal 102 (figure 6).

Notamment, la formation de ce transistor principal 102 comprend une croissance épitaxiale de l'empilement principal 202 sur une première face d'un deuxième substrat 500, par exemple un substrat de silicium. La croissance épitaxiale peut notamment comprendre en premier lieu la formation de la couche canal principale 202b, puis en second lieu, la formation de la couche barrière principale 202a. De manière avantageuse, la formation de la couche canal principal peut être précédée de la formation d'une couche d'adaptation principale (sur laquelle doit reposer la couche canal principale). La couche d'adaptation principale est notamment destinée à limiter la formation des dislocations dans la couche canal principal.

La croissance épitaxiale est suivie de la formation, en recouvrement de la couche barrière principale 202a, d'une deuxième couche isolante 200b, qui comprend par exemple du dioxyde de silicium.

Le dépôt de la deuxième couche isolante 200b est alors suivi de la formation d'une deuxième électrode de source 203a, d'une deuxième électrode de drain 204a et d'une deuxième électrode de grille 205a.

Le procédé de fabrication comprend également une étape d'assemblage du transistor additionnel 101 et du transistor principal 102. A cet égard, l'étape d'assemblage est exécutée par mise en contact de la première couche isolante 200a avec la deuxième couche isolante 200b, et de sorte que la première électrode de source 203b et la première électrode de drain 204b soient dans le prolongement, respectivement, de la deuxième électrode de source 203a et la deuxième électrode de drain 204a.

En d'autres termes, l'assemblage de la première couche isolante avec la deuxième couche isolante forme la couche isolante 200. L'assemblage de la première électrode de source 203b avec la deuxième électrode de source 203a forme l'électrode de source 203. L'assemblage de la première électrode de drain 204b avec la deuxième électrode de drain 204a forme l'électrode de drain 204. La première électrode de grille 205b et la deuxième électrode de grille 205a restent pour leur part indépendantes l'une de l'autre.

Il est par ailleurs notable que cette étape d'assemblage peut se faire selon un mode plaque à plaque. Plus particulièrement, le procédé peut comprendre la formation d'une pluralité de premiers transistors formés sur le premier substrat, et une pluralité de transistors principaux formés sur le deuxième substrat. Ces deux substrats sont ensuite assemblés de manière à mettre chaque transistor additionnel en vis-à-vis d'un transistor principal.

De manière alternative, l'assemblage peut comprendre une étape de préhension/positionnement (« Pick and Place » selon la terminologie Anglo-Saxonne). Notamment, chaque transistor additionnel peut être placé de manière individuelle sur chaque transistor principal formé sur le deuxième substrat.

Enfin, et toujours de manière alternative, les transistors principaux et les transistors additionnels sont tous singularisés, et ensuite assemblés deux-à-deux.

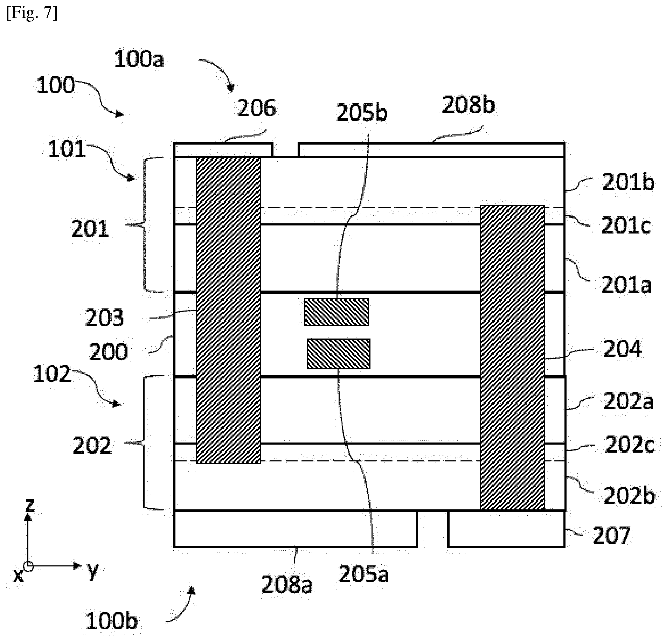

Dans une dernière étape, les plots source et grille sont formés par amincissement et gravure du premier substrat (figure 7).

Le dispositif électronique selon la présente invention est avantageusement mis en œuvre dans un système de gestion/consommation d'énergie électrique.

Plus particulièrement, le système de gestion peut comprendre un moyen de stockage d'énergie et un voie de consommation de ladite énergie. Le moyen de stockage est par exemple une batterie ou un accumulateur.

La voie de consommation peut être un moteur électrique. Ainsi, le dispositif électronique 100 selon la présente invention est avantageusement mis en œuvre dans un véhicule (voiture, camion, vélo, train) électrique.

## Revendications

1. Dispositif électronique comprenant un transistor HEMT, dit transistor principal, et au moins un autre transistor HEMT, dit transistor additionnel, le transistor principal et le transistor additionnel étant pourvus, respectivement, d'un empilement principal et d'un empilement additionnel entre lesquels est intercalée une couche isolante, l'empilement principal et l'empilement additionnel s'étendant, de la couche isolante vers, respectivement, une face arrière et une face avant du dispositif électronique, et comprennant chacun, à partir de la couche isolante, une couche barrière et une couche canal qui, lorsque le transistor HEMT considéré passe d'un état non-passant vers un état passant, est apte à former une couche de conduction, le transistor principal et le transistor additionnel comprenant une électrode de drain commune et, respectivement, une électrode de source principale et une électrode de source additionnelle, agencées de sorte que des chemins de conduction électrique susceptibles d'être formés par les deux couches de conduction soient connectés en parallèle lorsque l'un et l'autre des transistors HEMT sont dans l'état passant, le passage de l'un de l'état non-passant et de l'état passant vers l'autre de ces deux états, étant contrôlé de manière indépendante pour l'un et l'autre du transistor principal et du transistor additionnel via, respectivement, une électrode de grille principale et une électrode de grille additionnelle.

2. Dispositif selon la revendication 1, dans lequel l'électrode de drain traverse la couche isolante, et s'étend de part et d'autre de ladite couche isolante pour contacter électriquement la couche canal de l'un et l'autre du transistor principal et du transistor additionnel, avantageusement, le dispositif électronique comprend un plot, dit plot drain, disposé sur la face arrière et permettant de contacter électriquement l'électrode de drain.

3. Dispositif selon la revendication 1 ou 2, dans lequel ledit dispositif électrique comprend un plot, dit plot de grille principal, disposé sur la face arrière et permettant de contacter électriquement l'électrode de grille principale et un plot, dit plot de grille additionnel, disposé sur la face avant et permettant de contacter électriquement l'électrode de grille additionnelle.

4. Dispositif selon l'une des revendications 1 à 3, dans lequel le transistor principal et le transistor additionnel sont des transistors HEMT en mode enrichissement, et dans lequel l'électrode de source principale et l'électrode de source additionnelle forment une unique électrode de source, avantageusement, l'électrode de source traverse la couche isolante, et s'étend de part et d'autre de ladite couche isolante pour contacter électriquement la couche canal de l'un et l'autre du transistor principal et du transistor additionnel.

5. Dispositif selon la revendication 4 dans lequel ledit dispositif électronique comprend un plot dit plot source permettant de contacter électriquement l'électrode de source.

6. Dispositif selon la revendication 5, dans lequel le plot source est disposé sur la face avant.

7. Dispositif selon l'une des revendications 1 à 3, dans lequel le transistor principal et le transistor additionnel sont des transistors HEMT en mode déplétion, et sont chacun cascodés avec un transistor MOSFET dit, respectivement, transistor MOSFET principal et transistor MOSFET additionnel.

8. Dispositif selon la revendication 7, dans lequel le transistor MOSFET principal et le transistor MOSFET additionnel sont agencés pour imposer, de manière indépendante, un état passant ou un état non-passant, respectivement, au transistor principal et au transistor additionnel.

9. Dispositif selon la revendication 7 ou 8, dans lequel ledit dispositif électronique comprend en outre deux plots dits plot source principal et plot source additionnel permettant de contacter électriquement, respectivement, l'électrode de source principale et l'électrode de source additionnelle, le plot source principal et le plot source additionnel étant disposés, respectivement, sur la face arrière et sur la face avant.

10. Dispositif selon l'une des revendications 1 à 9, dans lequel l'empilement principal et l'empilement additionnel sont essentiellement identiques.

11. Dispositif selon l'une des revendications 1 à 10, dans lequel le transistor principal et le transistor additionnel présentent une tension de seuil identique.

12. Dispositif selon l'une des revendications 1 à 10, dans lequel le transistor principal et le transistor additionnel présentent chacun, respectivement, une tension de seuil principale et une tension de seuil additionnelle différentes l'une de l'autre.

13. Dispositif selon l'une des revendications 1 à 12, dans lequel les deux couches canal comprennent du GaN et les couches barrière comprennent un alliage ternaire d'AlGaN.

14. Dispositif selon l'une des revendications 1 à 13, dans lequel la couche isolante comprend un matériau diélectrique, avantageusement, du dioxyde de silicium.

15. Boîtier électronique comprenant :
- le dispositif électronique selon l'une des revendications 1 à 14 ;
- un moyen de contrôle du passage de l'un de l'état non-passant et de l'état passant vers l'autre de ces deux états, du transistor principal et du transistor additionnel, le moyen de contrôle étant configuré pour rendre passant le transistor additionnel dès lors que le transistor principal est lui-même dans l'état passant et que le courant le traversant est supérieur à une valeur seuil.
